# EUROPEAN PATENT APPLICATION

(11) **EP 0 684 646 A1**
(43) Date of publication of application: **29.11.1995**
(21) Application number: 95107693.4
(22) Date of filing: 19.05.1995
(51) Int. Cl.: H01L 23/525

(54) **Antifuse and method of manufacturing it**

(30) Priority: 20.05.1994 US 246529
(71) Applicant: TEXAS INSTRUMENTS INCORPORATED, Dallas Texas 75265 (US)
(72) Inventor: Kwok, Siang P., Dallas, TX 75248 (US); Amerasekera, E. Ajith, Plano, TX 75023 (US)
(74) Representative: Schwepfinger, Karl-Heinz, Dipl.-Ing.

(57) **Abstract**

A low leakage current antifuse (70, 98, or 100) is provided for use in user-programmable integrated circuitry. The antifuse has first (74) and second (96 or 110) connection metal layers for providing electricity to the antifuse. Between the metal layers is a dielectric layer (92 or 102), and between t he dielectric layer and at least one of the metal layers is a Schottky barrier layer (86, 94, or 108). The Schottky barrier layer minimizes the leakage current in the antifuse. More specifically,the barrier metal layer is a refractory metal having a work function substantially between 4.5 to 5.5eV.

## Description

### TECHNICAL FIELD OF THE INVENTION

The present invention relates generally to semiconductor devices and their fabrication and, more particularly, to an antifuse and method for manufacturing same.

### BACKGROUND OF THE INVENTION

Conventional methods of fabricating integrated electronic circuits set all internal circuit connections during the manufacturing process. However, because of high development costs and high manufacturing tooling costs of such circuits, new designs are emerging that permit a user to configure or program integrated circuits for specific applications in the field after their purchase. Such circuits are called user-programmable circuits, and they permit a user to program the electrical connections of the circuit by either selectively opening or closing a series of programmable links. The programmable links are electrical interconnects that are electronically forced electrically open or closed at selectable nodes in the circuit by the user after the integrated circuit has been packaged.

An antifuse, which is one type of programmable link, permits a user to program the integrated circuit by creating a short between two conductors to which the original open antifuse connects. Antifuses consist typically of two conductor or semiconductor elements that have a dielectric or insulating material sandwiched between them. During programming, the dielectric is broken down at selected points between the conductive elements by a current developed from a predetermined programming voltage (breakdown voltage) applied to the conductive elements of selected links. This electrically connects the conducting or semiconducting elements to the conductive elements.

One type of user programmable circuit known as a field programmable gate array (hereinafter FPGA) uses an interlay of amorphous silicon (hereinafter a-Si) as the dielectric sandwiched between two metal layers. Refractory metals such as titanium tungsten (TiW), tungsten (W), or titanium nitride (TiN) are prime examples of metals used to sandwich the a-Si.

Undesirable capacitances and leakage currents of unused antifuses are problems that occur in user programmable integrated circuits that use antifuses. That is, the antifuse, which is normally an open device in its unprogrammed condition, has an associated leakage current and some degree of capacitance between the connectors. A typical leakage current for previously developed antifuses would be 1-2nA at 5.5V, with a breakdown voltage of 10V. Leakage currents and capacitances of antifuses adversely affect user programmable circuits that use them.

One approach to limit leakage currents in antifuses has been to increase the thickness of the dielectric between the connectors. Unfortunately, increasing the thickness of the dielectric increases the programming or breakdown voltage of the dielectric thereby requiring a higher programming voltage for the antifuse. A higher breakdown voltage results in the need for high power drivers (transistors) on the antifuse chip so that programming of the antifuses can be achieved. This need for high power drivers on a chip for programming reduces performance of the chip and increases its cost.

One approach to achieve a lower breakdown voltage for an antifuse has been to use a thin dielectric layer between the metal connector layers. A thin dielectric between metal layers, however can result in a high interconnect capacitance for the antifuse. A high capacitance antifuse increases the capacitance of the antifuse circuit which in turn decreases the speed of the circuit.

Prior approaches in designing antifuses have, therefore, been forced to balance the need to limit leakage current by increasing the dielectric thickness with the need to reduce or maintain the breakdown voltage for the antifuse by decreasing the dielectric thickness.

Another approach has been to improve the material of dielectric layer between the metal layers. Unfortunately, this approach involves difficult material processing that is not easily replicated and alone does not sufficiently reduce antifuse leakage current.

### SUMMARY OF THE INVENTION

A need exists, therefore, for an antifuse that has a low leakage current.

An additional need exists for a low leakage current antifuse with a low breakdown voltage.

A further need exists for an antifuse having low leakage current without variability in its breakdown voltage.

An additional need exists for a low leakage current and low breakdown voltage antifuse that may be fabricated by semiconductor processing techniques with acceptable yields.

The present invention, accordingly provides an antifuse with a low leakage current. Moreover, the present invention provides a low leakage current antifuse with a low breakdown voltage. Also, the present invention provides a low leakage current antifuse without variability in its breakdown voltage.

The present invention provides an antifuse for use in user-programmable integrated circuitry. The present antifuse has first and second connection metal layers for providing electricity to the antifuse. Between the metal layers is a dielectric layer, and between the dielectric layer and at least one of the metal layers is a Schottky barrier layer. The Schottky layer minimizes the leakage current in the antifuse. More specifically, the barrier metal layer is a refractory metal having a work function substantially between 4.5 to 5.5eV.

The present antifuse provides a technical advantage of having lower leakage currents by orders of magnitude over previously developed antifuses. The lower leakage currents provided with the present antifuse allows for greater integration of antifuses into a semiconductor circuit.

An additional technical advantage of the present low leakage current antifuse is its low breakdown voltage. The present antifuse can also provide low leakage currents without variability in breakdown voltage. The low breakdown voltage of the present antifuse eliminates the need for high voltage transistors for programming the circuit and reduces the cost to fabricate and the size of the present antifuse.

The antifuse of the present invention is manufacturable by repeatable processes that provide acceptable yields. An additional technical advantage of the present invention is that it provides a stable metal to dielectric interface that is not susceptible to interdiffusion of layers. Additionally, the present invention provides a technical advantage of being compatible with the temperatures required in common semiconductor processing.

Yet another technical advantage of the present invention is that it can be used to provide both symmetrical and asymmetrical antifuse configurations within an antifuse circuit.

### BRIEF DESCRIPTION OF THE DRAWINGS

The present invention is best understood by reference of the following detailed description of illustrative embodiments, when read with a view to the accompanying figures, wherein:
FIGURE 1 illustrates an energy band diagram for a metal/dielectric/metal double Schottky barrier antifuse;
FIGURE 2 depicts the relationship between breakdown voltage and leakage current for a model antifuse having a silicon dielectric and Schottky barrier materials having different work functions.
FIGURES 3a and 3b depict the relationship between breakdown voltage and leakage current for a model antifuse having an a-Si dielectric and Schottky barrier materials having different work functions;
FIGURE 4 graphs actual data for the relationship between the Schottky barrier height to metal work function for different barrier metals for both P-type and N-type a-Si dielectrics;
FIGURES 5a-5h illustrate the formation of a double Schottky barrier antifuse;
FIGURE 6 depicts a cross-sectional view of a single Schottky barrier antifuse; and
FIGUREs 7a-7d illustrate an alternative methodology for the formation of a double Schottky barrier antifuse.

### DETAILED DESCRIPTION OF THE INVENTION

The present invention can be understood more fully referring to the following detailed description when read together with the accompanying figures, wherein like numerals are used for like and corresponding parts.

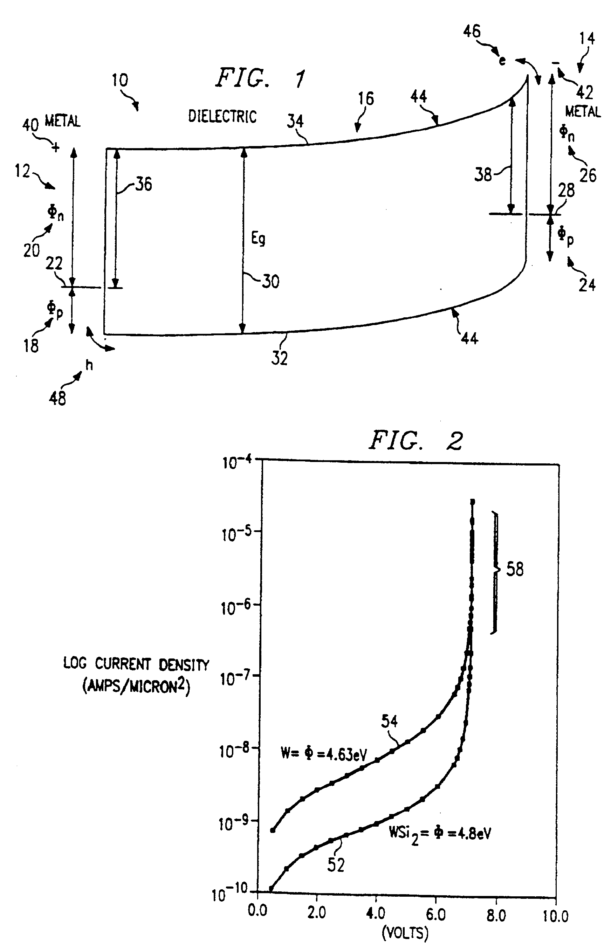

FIGURE 1 illustrates an energy band diagram 10 for a metal/dielectric/metal double Schottky barrier antifuse. Energy diagram 10 includes first metal region 12 and second metal region 14. Between first 12 and second 14 metal regions is dielectric region 16. In the antifuse structure represented by energy diagram 10 of FIGURE 1, the metal regions have been chosen so as to provide a high Schottky barrier height at the interface between a metal region and the dielectric region.

The high Schottky barrier height is achieved by selecting materials for the metal regions with high work functions. The work function (^{Φ}) of a material is the minimum energy required to liberate an electron from the material at absolute zero temperature. The work function of a material comprises two components as shown in FIGURE 1. For metal region 12, the work function is the sum of the work function for the holes (h) in the metal, represented by ^{Φ_{*p*}} 18 plus the work function for the electrons (e) in the metal, represented by ^{Φ_{*n*}} 20. The demarcation between ^{Φ_{*p*}} 18 and ^{Φ_{*n*}} 20 is referred to as Fermi level 22.

Fermi level 22 is the maximum energy level that an electron can occupy in a material at a temperature of absolute zero. The work function of metal region 12 is a function of its material composition. The Fermi level for region 12 can also be adjusted through material selection. In a similar manner, metal region 14 has associated hole work function ^{Φ_{*p*}} 24 and electron work function ^{Φ_{*n*}} 26, with Fermi level 28 separating the two.

Between metal region 12 and metal region 14 of FIGURE 1 is dielectric region 16. Dielectric region 16 is represented in FIGURE 1 by its bandgap energy ^{(*E*_{*g*})} 30. Bandgap 30 of dielectric region 16 is the energy level difference between the electron valence band, represented by line 32, and the electron conduction band, represented by line 34, for the material of dielectric region 16. The valence band is the electron energy band in which electrons cannot move freely, and the conduction band is the electron energy band in which electrons can move freely. Therefore, for an electron to move in dielectric region 16, it must have sufficient energy to jump from valence band 32 to conduction band 34.

The energy band diagram of FIGURE 1 shows two Schottky barriers. The first is between metal region 12 and dielectric region 16. The Schottky barrier is the difference between conduction band energy level 34 of dielectric region 16 and the Fermi level of either metal region. For the interface between metal region 12 and dielectric region 16, the Schottky barrier is represented by line 36, offset from the actual interface for illustrative purposes only. In a similar manner, the Schottky barrier between metal region 14 and dielectric region 16 is represented by line 38, also offset for illustrative purposes only. The Schottky barrier is the minimum amount of energy an electron in a metal region must have to be conducted in dielectric region 16. Energy is typically imparted to an electron through thermal excitation, and once an electron receives sufficient thermal energy it can jump to conduction band 34 of dielectric region 16 and be conducted via thermionic emission. The difference between the Fermi level of the metal region and the conduction band level of the dielectric region is typically referred to as the Schottky barrier height. Schottky barriers represented by lines 36 and 38 will therefore be referred to as either the Schottky barrier or Schottky barrier height for the metal/dielectric interface.

Also depicted in FIGURE 1 are the results when a positive potential 40 is applied to metal region 12 and a negative potential 42 is applied to metal region 14. This potential difference causes valence 32 and conduction 34 bands for dielectric region 16 to be shifted upwards as represented by curve 44. This upward shift represented by curve 44 increases the Schottky barrier at Schottky barrier 38 versus that at Schottky barrier 36. Therefore, for electrons 46 to travel from metal region 14 to metal region 12, they must have sufficient energy to jump up to shifted conduction band 34 of dielectric region 16 so that they can travel to metal region 12. The Schottky barrier presents an obstacle for the conduction of electrons 46 from region 14 to region 12 and, therefore, acts as a barrier to leakage current which flows in the opposite direction to electron 46. It is noted that reversing the bias to the antifuse represented in FIGURE 1 will cause the observed shift in Fermi levels for metal regions 12 and 14 to reverse.

Leakage current in the antifuse represented by energy band diagram 10 of FIGURE 1 also results from the movement of holes 48 from metal region 12, through dielectric region 16, and to metal region 14. To minimize leakage current in the antifuse, ^{Φ_{*p*}} 18 and ^{Φ_{*p*}} 24 for metal regions 12 and 14 must be set sufficiently high so that leakage current through hole 48 conduction does not become a significant factor. For example, if ^{Φ_{*p*}} 18 of region 12 is set too low, *i.e.*, ^{Φ_{*n*}} 20 approaches ^{*E*_{*g*}} 30 of dielectric region 16, then holes 48 in region 12 can be easily transported into dielectric region 16. Because the mobility of holes 48 is much less than that for electrons 46, and because the electron concentrations in the barrier metals is much higher than the hole concentrations, ^{Φ_{*n*}} 20 and 26 can be made much larger than ^{Φ_{*p*}} 18 and 24, respectively. ^{Φ_{*p'*}} however, cannot be made too low else leakage current by hole 48 conduction will increase to the point where the antifuse's operation is affected.

In summary, as shown in FIGURE 1, by appropriately selecting the materials for metal region 12 and metal region 14 to have a suitable ^{Φ_{*n*}} 20 or 26, the Schottky barrier or Schottky barrier height between the metal regions and the dielectric region may be sufficient to minimize the flow of electrons and holes to achieve a low leakage current antifuse.

FIGURE 2 shows the results of a PICES computer model for a double Schottky barrier antifuse having Schottky barrier materials with different work functions. The voltage in volts (V) is represented on the X-axis, and leakage current in amps/micron² is represented on the Y-axis, with the Y-axis being a log scale. The antifuse modeled in the data of FIGURE 2 is a double Schottky barrier antifuse having a dielectric thickness of 1,000A and a surface area of ^{*1*µ*m*²}. The hole mobility in the dielectric is 0.1 and the electron mobility is 10. The bandgap ^{*E*_{*g*}} of the dielectric is set at 1.08eV, which is a typical bandgap for a silicon dielectric.

The curves of FIGURE 2 represent the relationship between voltage and current density for barrier materials with different work functions and intrinsic crystalline silicon with a bandgap of 1.08eV. Curve 52 represents a material with a work function of 4.8eV, and curve 54 represents a material with a work function of 4.63eV. It is known that tungsten (W) has a work function of approximately 4.63eV and tungsten disilicide (WSi₂) has a work function of approximately 4.8eV.

The model antifuse of FIGURE 2 shows that leakage current for the antifuse can be controlled by selecting Schottky barrier junction materials that have a high work function and yet provide low leakage current with a constant breakdown voltage. The vertical portion of curves 52 and 54 of FIGURE 2, represented by region 58, shows an area of constant breakdown voltage operation for the antifuse. Therefore, by forming an antifuse including WSi₂ as the Schottky junction barrier material, the antifuse can be operated at a near constant breakdown voltage with a leakage current of approximately 1nA/mm² at a bias of approximately 5V. A similar region of operation for an antifuse with W Schottky barriers (curve 54) is shown in FIGURE 2.

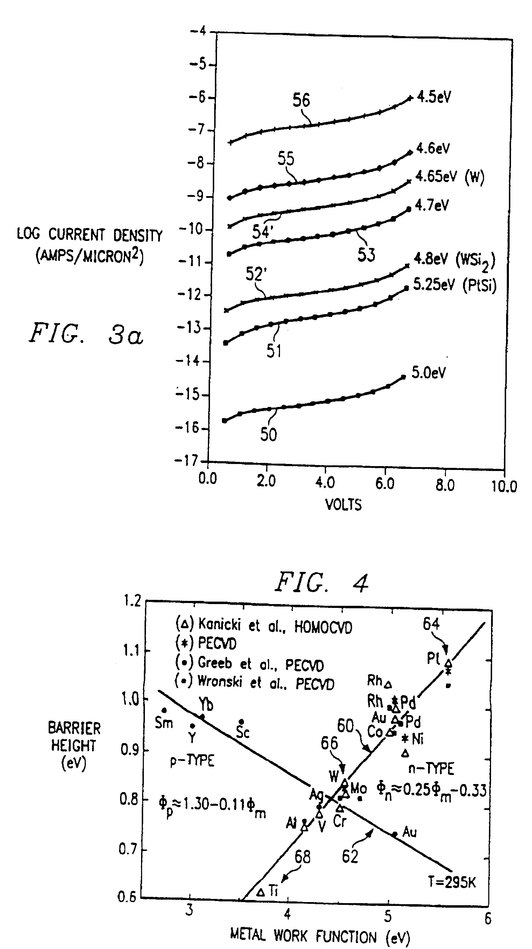

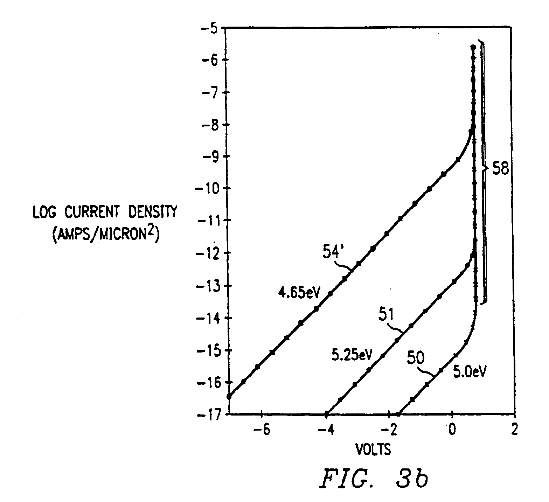

FIGURE 3a shows PICES computer model theoretical data for the relationship between voltage and leakage current for an antifuse and several Schottky barrier materials with different work functions. The voltage in volts is represented on the X-axis, and leakage current in A/mm² is represented on the Y-axis, with the Y-axis being a log scale. The model antifuse is a double Schottky barrier antifuse having a dielectric thickness of 1,000A and a surface area of 1 mm². The hole mobility in the dielectric is 0.1 and the electron mobility is 10. The bandgap ^{*E*_{*g*}} of the dielectric is set at 1.63eV, which is a typical bandgap for a-Si.

The curves in FIGURE 3a represent the relationship between voltage and current density for barrier materials with different work functions. Curve 50 represents a material with a work function of 5.0eV. Curve 51 represents a material with a work function of 5.25eV. In a similar manner, curve 52' represents a material with a work function 4.8eV (see FIGURE 2), curve 53 a material with a work function of 4.7eV, curve 54' a material with a work function of 4.65eV (see FIGURE 2), curve 55 a material with a work function of 4.6eV, and curve 56 a material with a work function of 4.5eV. Additionally, it is known through experimentation that platinum silicide (PtSi) has a work function very close to curve 51 at 5.25eV. The curves of FIGURE 3a show the relationship between voltage and current density for a double Schottky dielectric barrier antifuse for various barrier materials and an a-Si. These curves show that the leakage current of an antifuse is a factor that can be controlled by appropriate material selection for Schottky barriers at the interface between the dielectric and metal layers of the antifuse.

FIGURE 3b shows an extension of a portion of the data from FIGURE 3a with the voltage and current density ranges extended for curves 50, 51, and 52' of FIGURE 3a, and presenting the current density (Y-axis) on a log scale. FIGURE 3b demonstrates that the leakage current of the present antifuse employing Schottky barrier metal layers and an a-Si dielectric can be reduced while holding the breakdown voltage constant. FIGURE 3b confirms that the antifuse model of FIGURE 2 that used a silicon dielectric holds true with an a-Si dielectric.

FIGUREs 2 through 3b show that it is possible to limit the amount of leakage current in an antifuse by forming a Schottky barriers at the two interfaces of the metal and ^{α-*Si*} dielectric. This is generally accomplished by using high work function materials, *e.g*., 4.5 to 5.5eV, at the Schottky barrier. Note, that simply using high bandgap materials may not provide acceptable results. In order to decrease leakage current, yet maintain breakdown voltage constant, the selection of the Schottky barrier material and operation thereof must be coordinated. FIGURE 3 illustrates how Schottky barrier material selection enables the present antifuse to be a low leakage current and constant breakdown voltage device. Also, as shown in FIGURE 1, if the ^{Φ_{*p*}} of the barrier material is too low, leakage current by hole conduction may become unacceptable.

FIGURE 4 depicts the relationship between the Schottky barrier height of a metal to a-Si dielectric interface to the work function for various metals used as the Schottky barrier metal. The X-axis represents the metal work function in eV, and the Y-axis represents the Schottky barrier height for the junction. Curve 60 represents the relationship between Schottky barrier height and the work functions for various metals interfacing with an N-type a-Si dielectric. Curve 62 represents the relationship between the Schottky barrier height and the work functions for various metals interfacing with a P-type a-Si dielectric. The dielectric material used in obtaining the data of FIGURE 4 was a-Si. The data of FIGURE 4 is from *Amorphous & Microcrystalline Semiconductor Devices*, Vol. II, Chapter 5, by Jerzy Kanichi, Atech House, 1992.

Curves 60 and 62 represent the average barrier height for the various metals from the plotted data. The data reveals that, for example, Pt represented by point 64 with an actual work function of approximately 5.5eV, will provide a Schottky barrier height of approximately 1.1eV (see FIGURE 4). The Schottky barrier height resulting when using Pt as the barrier metal is significantly higher than that resulting from using W, represented by point 66, or Ti represented by point 68. The curves of FIGURE 4, which use actual metal work functions for different barrier metals as opposed to the theoretical values of FIGURES 2 through 3b, demonstrate that the choice of barrier metals directly determines the Schottky barrier height when using an a-Si dielectric. Also, that generally, using metals with higher work functions with an N-type a-Si dielectric provide Schottky barriers with higher barrier heights. Conversely, using metals with lower work functions with a P-type a-Si dielectric provide Schottky barriers with higher barrier heights. This increased Schottky barrier height at the junction of the metal and a-Si dielectric minimizes the leakage current from an antifuse, and is how the present antifuse achieves a technical advantage of low leakage current.

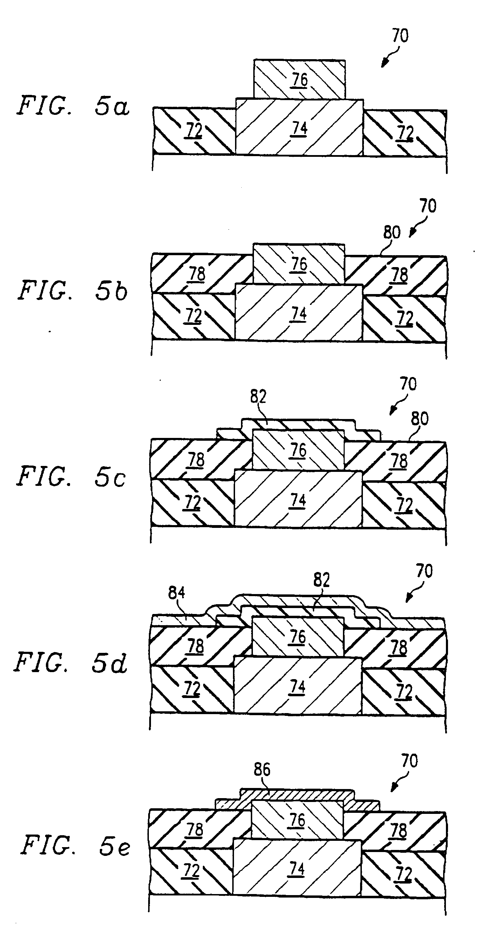

FIGURE 5a shows the beginning of an antifuse fabrication process flow used to illustrate certain aspects of the present antifuse. In FIGURE 5a, antifuse 70 includes first multi-level oxide (MLO1) layer 72 and connection metal layer or first metal (MET1) layer 74. MET1 layer 74 is generally formed and planarized prior to the formation of MLO1 layer 72. MLO1 layer 72 is typically on the order of 5,000A. MET1 layer 74 typically comprises aluminum silicon copper (AlSiCu) or AlSiCu on TiW, with a thickness on the order of 7,000A and provides electricity to the antifuse.

Formed outwardly from MET1 layer 74 is a conductive layer or bottom of the antifuse (FBOT) 76. In the embodiment of the present antifuse depicted in FIGURES 5a-5h, FBOT 76 typically includes a layer on the order of 2,000 to 3,000A of TiW. FBOT 76 may be embodied in a pillar or stack formed by the approaches described in U.S. Patent Application Serial No. 08/178,185, filed January 6, 1994 by S. P. Kwok, and entitled *Low Capacitance Antifuse and Method for Manufacture*, and assigned to TEXAS INSTRUMENTS, INCORPORATED of Dallas, Texas (hereinafter "*Kwok*"). For purposes of this use, the description of *Kwok* is incorporated by reference.

FIGURE 5b shows the completion of the next steps in the antifuse formation process of the present invention. Formed outwardly from MLO1 layer 72 is multi-level oxide (MLO2) layer 78 comprising on the order of 10,000A of dielectric material. MLO2 layer 78 may be formed, for example, by spin-on-glass (SOG) techniques or by, for example, plasma enhanced decomposition of tetraethyl orthosilicate (PTEOS). If MLO2 layer 78 is formed by PTEOS, then top surface 80 of MLO2 layer 46 may require planarization prior to exposing FBOT 76. One method for planarizing top surface 80 of antifuse 70 is by the etch back pattern resist technique described in *Kwok.* FIGURE 5b also shows FBOT 76 exposed above top surface 80 of MLO2 layer 78. FBOT 76 may be exposed above MLO2 layer 78 by a selective etching process. An example of a selective etching process suitable for exposing FBOT 76 is fully described in *Kwok*. It is noted that MET1 layer 74 and FBOT 76 may be formed first, and that a single MLO layer incorporating MLO1 layer 72 and MLO2 layer 78 may then be formed.

FIGURE 5c shows the results of further processing in the formation of antifuse 70. Dielectric layer 82 has been deposited outwardly from MLO2 layer 78 and FBOT 76. Prior to depositing dielectric layer 82, the top surface of FBOT 76 may be pre-sputter cleaned. The top surface of FBOT 76 may also be cleaned by the approach described in U.S. Patent Application Serial No. 08/178,208, filed January 6, 1994 by S. P. Kwok, and entitled "*Limited Metal Reaction for Contact Cleaning and Improved Metal-to-Metal Antifuse Contact Cleaning Method and Apparatus*," and assigned to TEXAS INSTRUMENTS, INCORPORATED of Dallas, Texas (hereinafter *Kwok-2*). For purposes of this use, the description of *Kwok-2* is incorporated by reference.

Following cleaning, dielectric layer 82 may be formed outwardly from MLO2 layer 78 and FBOT layer 76. Dielectric layer 82 may be formed by plasma-enhanced chemical-vapor deposition (PECVD) or any other suitable process. Dielectric layer 82 may be a-Si or compounds thereof, silicon nitride (SiN) or compounds thereof, a-Si carbide or compounds thereof, amorphous carbon (a-C) or compounds thereof, or any other dielectric material suitable for forming an antifuse. Hereinafter, a-Si will be the dielectric material referred to, it being understood that other dielectric materials not specifically referred to, may be substituted for a-Si without departing from the inventive concepts of the present invention.

a-Si layer 82 is on the order of 500 to 1,000A. Once a-Si layer 82 is formed, its dimensions must be delineated and defined through, for example, photoresist masking and etching. The width of a-Si layer 82 must be sufficient to cover all of FBOT 76. Therefore, if FBOT 76 has a dimension of, for example, 1,400A, then the width of a-Si layer 82 must be, for example, 1,800A. This would ensure full coverage of FBOT 76.

FIGURE 5d shows the results of further steps in completing antifuse 70 of the present invention. Barrier metal layer 84 has been formed outwardly from a-Si layer 82 and MLO2 layer 78. Barrier metal layer 84 may be formed through sputter deposition and results in a layer of barrier metal on the order of 500A thick. Barrier metal layer 84 may be any refractory metal or compounds thereof which has a work function in the range of 4.5 to 5.5eV. Barrier metal layer 82 is selected to control the Schottky barrier height of antifuse 70 as described previously in connection with FIGURES 1 through 4. Refractory metals cobalt (Co), Ti, W, Pt, palladium (Pd), molybdenum (Mo), and compounds thereof, including their nitride compounds, have been found to be suitable barrier metals. The term refractory metal hereinafter refers to refractory metals and compounds thereof. In a preferred embodiment, Pt has been found to be a suitable barrier metal. Once sintered, Pt forms PtSi layer 86 (see FIGURE 5e) which has wide-spread commercial usage and known reliability.

FIGURE 5e shows the results of further processing in the formation of antifuse 70 of the present invention. Following the deposition of barrier metal layer 84, Schottky barrier layer 86 may be formed from barrier metal layer 84 and a-Si layer 82. Barrier metal layer 84 and a-Si layer 82 may be sintered, for example, at 350° to 450°C to form a silicidized Schottky barrier layer 86. Sintering allows an interface layer between the two layers to develop where the material of the two layers come into intimate contact through interdiffusion. In the embodiment where barrier metal layer 84 is Pt, Schottky barrier layer 86 is PtSi. The dimensions of Schottky barrier layer 86 may be delineated and the unwanted amounts of Schottky barrier layer 86 are removed using, for example, aqua regia, as is well-known in the art.

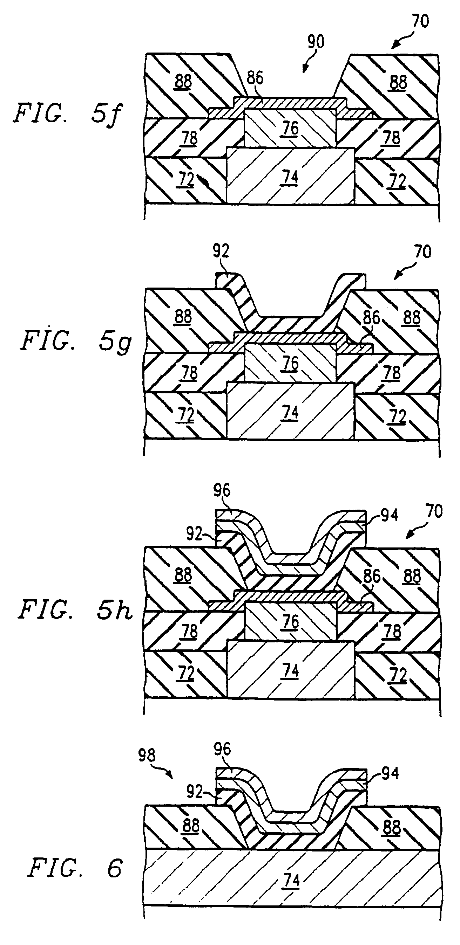

FIGURE 5f shows the results following the next step of fabricating the antifuse of the present invention. MLO3 layer 88 has been formed outwardly from MLO2 layer 78 and Schottky barrier layer 86. MLO3 layer 88 may be formed, for example, by the SOG and PTEOS processes previously described. Formed in MLO3 layer 88 is via 90. Via 90 may be formed in MLO3 layer 88, for example, through masking and etchback as is well-known in the art. MLO3 layer 88 may be, for example, on the order of 1,000 to 5,000A with the opening of via 90 in the order of 800A. It is noted that via 90 is a relatively shallow, low aspect ratio via. MLO3 layer 88 may be planarized by techniques described and taught in *Kwok* prior to forming via 90.

FIGURE 5g shows the result of further steps in completing antifuse 70 of the present invention. Prior to depositing a-Si layer 92 outwardly from MLO3 layer 88 and in via 90, the top surface of Schottky barrier layer 86 may be pre-sputter cleaned as described in *Kwok-2*. Following cleaning, a-Si layer 92 may be formed outwardly from Schottky barrier layer 86 and MLO3 layer 88. a-Si layer 92 is on the order of 1,000 to 2,000A. The dimensions of a-Si layer 92 may be delineated and unwanted portions removed by, for example, etchback resulting in a-Si layer 92 as shown in FIGURE 5g.

FIGURE 5h shows the results of the final processing steps of antifuse 70 of the present invention. In FIGURE 5h, a barrier metal layer has been deposited outwardly from a-Si layer 92 similar in manner to the formation of barrier metal layer 84. The barrier metal layer may be on the order of 500A. The barrier metal layer may be a refractory metal or compounds thereof. The barrier metal layer may be the same as barrier metal layer 84 but does not have to be. Once the barrier metal layer is formed, it is sintered at approximately 350° to 450°C forming a self-aligned silicide. The self-aligned silicide forms Schottky barrier layer 94 outwardly from a-Si layer 92. During the sintering process, a portion of a-Si layer 92 is consumed. For example, for a PtSi barrier metal layer, for every Pt atom one Si atom is consumed. The thickness of a-Si layer 92 must, therefore, be controlled to consider the consumption of some of the a-Si. Also, as depicted in FIGURE 5h, the unwanted portions of Schottky barrier layer 94 may be stripped by, for example, using aqua regia. Finally, second metal MET2 layer 96 may be formed outwardly from Schottky barrier layer 94 to provide the second connection metal layer for providing electricity to antifuse 70.

The formation of antifuse 70 of FIGURES 5a-5h provides numerous technical advantages. The Schottky barriers formed by sintering the barrier metal layers provide Schottky barriers with sufficient height to minimize leakage current in antifuse 70. The lower leakage current antifuse of the present invention allows a large number of antifuses to be integrated into densely-packed semiconductor devices. Additionally, by appropriately selecting the Schottky barrier metals forming these layers, the breakdown voltage of the Schottky barrier can be controlled to be constant as previously described in discussions with reference to FIGURE 3. Also, by including FBOT 76, the distance between connection metal layers 74 and 96 may be extended thereby decreasing the host interconnect capacitance of antifuse 70. This provides a technical advantage of a low capacitance antifuse.

Additionally, since the formation of Schottky barrier metal layers 86 and 94 of antifuse 70 may be by self-aligning processes, additional masking steps in order to define the orientation of the Schottky barrier layers may be eliminated. The processing described in conjunction with the formation of antifuse 70 of FIGURES 5a-5h are exemplary only. Many semiconductor processing techniques, as are well known in the art, may be used in forming antifuse 70 without departing from the inventive concepts of the present invention.

FIGURE 6 depicts a cross sectional view of single Schottky barrier antifuse 98 of the present invention. Antifuse 98 includes MET1 layer 74 with MLO3 layer 88 formed outwardly therefrom. MLO3 layer 88 has a via formed therein with a-Si layer 92 deposited in the via. Formed outwardly from a-Si layer 92 is Schottky barrier layer 94 formed by the processes previously described in connection with FIGURES 5a-5h. MET2 layer 96 is formed outwardly from Schottky barrier metal layer 94. Antifuse 98 may be formed by using the semiconductor processing techniques described previously in formation of antifuse 70 depicted in FIGURES 5a-5h. Other semiconductor processing techniques as are well-known in the art may also be used.

Antifuse 98 shows an antifuse structure with a single Schottky barrier metal layer employed. This provides antifuse 98 with a non-symmetrical or asymmetrical leakage current. Schottky barrier layer 94 in antifuse 98 presents a Schottky barrier to the flow of electrons from MET1 layer 74 to MET2 layer 96, but not in the reverse direction. This results in asymmetrical leakage currents which may be desirable in certain applications and also requires less processing steps thereby minimizing the expense in forming antifuse 98.

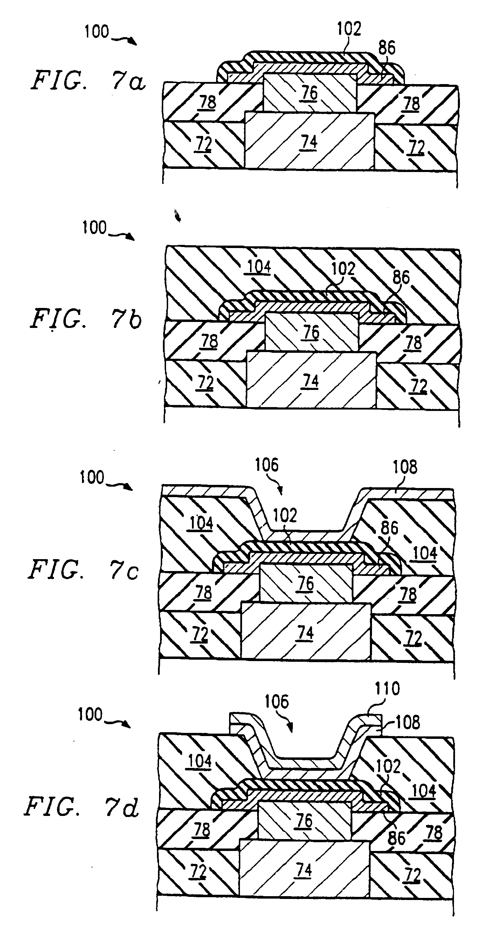

FIGURES 7a-7d illustrate an alternate methodology for the formation of a double Schottky barrier antifuse of the present invention. Antifuse 100 of FIGURE 7a is equivalent to antifuse 70 in FIGURE 5e following the formation of Schottky barrier layer 86. Antifuse 100 of FIGURE 7a differs from antifuse 70 of FIGURE 5e in that a-Si layer 102 has been formed outwardly from Schottky barrier layer 86 prior to further processing. Layer 102 comprises approximately 1,000 to 1,500A of a-Si. The dimensions of a-Si layer 102 are delineated and the unwanted a-Si is removed resulting in a-Si layer 102 covering Schottky barrier layer 86 as depicted in FIGURE 7a.

FIGURE 7b shows the results of further processing in the formation of antifuse 100. MLO3 layer 104 has been formed outwardly from MLO2 layer 78 and a-Si layer 102. MLO3 layer 104 may be formed by standard processing techniques as previously described in connection with FIGURES 5a-5h. MLO3 layer 104 may be on the order of 8,000 to 10,000A thick. MLO3 layer may require planarizing prior to further processing.

FIGURE 7c shows the results of additional processing steps in the formation of antifuse 100. Via 106 has been formed in MLO3 layer 104. Schottky barrier 108 has been formed in via 106 outwardly from a-Si layer 102 and MLO3 layer 104. Schottky barrier layer 108 may be, for example, on the order of 500A. Schottky barrier metal layer 108 may be formed by, for example, depositing a barrier metal layer outwardly from a-Si layer 102, and sintering at 350° to 450°C the barrier metal layer and a-Si layer 102 forming a self-aligned silicide layer. Schottky barrier layer 108 forms the second Schottky barrier junction in antifuse 100.

FIGURE 7d shows the results of the final processing of antifuse 100. Unwanted portions of Schottky barrier layer 108 may be removed by, for example, stripping with aqua regia. A second connection metal (MET2) layer 110 may be formed outwardly from Schottky barrier layer 108 as previously described for antifuses 70 and 98. Antifuse 100 of Figure 7d has a technical advantage of forming a self-aligned Schottky barrier layer in via 106. Antifuse 100 of FIGURE 7d also provides the other technical advantages previously identified for antifuses built in accordance with the present inventive methods.

Antifuses of the present invention may have many compositions and it is not intended that they be limited to the those shown in the figures. The Schottky barriers may be formed of numerous refractory metals and compounds thereof, as previously identified.

The present antifuse uses a Schottky barrier at the interface between the antifuse dielectric and the connection metal layers to form Schottky barriers that minimize leakage current in the antifuse. Antifuses of the present invention may also be low capacitance devices by using pillars or stacks to extend the distance between connection metal layers and still provide a uniform dielectric layer between the metal layers. The present antifuse provides technical advantages of uniform breakdown voltage and low leakage current. The present antifuses may have symmetrical or asymmetrical leakage currents depending on the number of Schottky barrier junctions in the antifuse.

Although the present invention has been described with reference to the above specified embodiments, the description is not meant to be construed in a limiting sense. Various modifications in the disclosed embodiment, as well as alternative embodiments of the invention, will become apparent to persons skilled in the art upon reference to the above description. It is, therefore, contemplated that the appended claims will cover such modifications that fall within this true scope of the invention.

## Claims

1. An antifuse for use in integrated circuitry, comprising:
first and second connection metal layers for providing electricity to the antifuse;
a dielectric layer between said first and second metal layers; and
a first barrier layer between the dielectric layer and at least one of the metal layers forming a Schottky barrier for minimizing leakage current in the antifuse.

2. The antifuse of Claim 1 wherein the barrier layer comprises a refractory metal.

3. The antifuse of Claim 1 or claim 2 wherein the refractory metal has a work function substantially between 4.5 to 5.5eV.

4. The antifuse of any preceding Claim, wherein the dielectric layer is a-Si.

5. The antifuse of any preceding Claim, further comprising a second barrier layer opposite the first barrier layer between the dielectric layer and the other metal layer, the second barrier layer forming a second Schottky barrier for minimizing leakage current in the antifuse.

6. The antifuse of Claim 5, wherein barrier layers comprise a refractory metal having a work function substantially between 4.5 to 5.5eV..

7. The antifuse of any preceding Claim, or each wherein the height of the Schottky barrier is substantially between 0.85 to 1.1eV.

8. The antifuse of any preceding Claim wherein the barrier layer and dielectric layer give the antifuse a substantially constant breakdown voltage.

9. A method for forming an antifuse for use in integrated circuitry, comprising the steps of:
forming first and second connection metal layers for providing electricity to the antifuse;
forming a dielectric layer between the first and second metal layers; and
forming a first Schottky barrier layer between the dielectric layer and at least one of the metal layers for minimizing the leakage current in the antifuse.

10. The method of Claim 9, further comprising forming the dielectric layer as a-Si.

11. The method of Claim 9 or claim 10, wherein the forming a first Schottky barrier layer step further comprises the steps of:
forming a second dielectric layer;
forming a barrier metal layer outwardly from the second dielectric layer; and
sintering the dielectric layer and the barrier metal layer in order to form a Schottky barrier junction.

12. The method of any of Claims 9 to 11 further comprising the step of forming a second Schottky barrier layer opposite the first Schottky barrier layer between the dielectric layer and the other metal layer.

13. The method of any of Claims 9 to 12, further comprising forming the or each Schottky barrier layers comprising a refractory metal having a work function substantially between 4.5 to 5.5eV.

14. The method of any of claims 9 to 13, further comprising providing the Schottky barrier having a height of substantially between 0.85 to 1.1eV.

15. The method of any of claims 9 to 14, further a method for forming an antifuse for use in user-programmable integrated circuitry, comprising the steps of:
forming the first connection metal layer;
forming the first dielectric layer outwardly from the first metal layer;
forming the barrier metal layer outwardly from the first dielectric layer;
forming the first Schottky barrier layer with a portion of the first dielectric layer and the barrier metal layer; and
forming the second connection metal layer outwardly from the Schottky barrier layer.

16. The method of Claim 15, further comprising, prior to the step of forming the first dielectric layer, the steps of:
forming a second dielectric layer outwardly from the first connection metal layer;
forming a second barrier metal layer outwardly from the second dielectric layer; and
forming a second Schottky barrier layer with the second dielectric layer and the second barrier metal layer.
